## Europäisches Patentamt
## European Patent Office
## Office européen des brevets

(19)

(11) Veröffentlichungsnummer: **0 131 725**
**A2**

(12) # EUROPÄISCHE PATENTANMELDUNG

(21) Anmeldenummer: **84106156.7**

(22) Anmeldetag: **30.05.84**

(51) Int. Cl.⁴: **H 04 B 7/005**

(30) Priorität: **01.06.83 DE 3319884**
**14.05.84 DE 3417776**

(43) Veröffentlichungstag der Anmeldung:
**23.01.85 Patentblatt 85/4**

(84) Benannte Vertragsstaaten:
**AT BE CH DE FR GB IT LI LU NL SE**

(71) Anmelder: **Horn, Manfred**
**Europaplatz 6**
**D-7000 Stuttgart 80(DE)**

(72) Erfinder: **Horn, Manfred**
**Europaplatz 6**
**D-7000 Stuttgart 80(DE)**

(54) Verfahren und Schaltungsanordnungen zur Kompensation von nichtlinearen Amplituden- und/oder Phasenverzerrungen.

(57) Verfahren zur Kompensation von nichtlinearen Amplituden- und/oder Phasenverzerrungen in nichtlinearen hochfrequenzseitigen Übertragungseinrichtungen von Übertragungssystemen für analoge oder digitale Übertragungssignale, insbesondere von nichtlinearen Verzerrungen in Mikrowellensendern, dadurch gekennzeichnet, daß im Übertragungssystem vor oder nach den nichtlinearen hochfrequenzseitigen Übertragungseinrichtungen aus dem Übertragungssignal in der Nieder-, oder Zwischen-, oder Hochfrequenzebene ein pulscodemoduliertes Signal abgeleitet wird, das in codierter Form eine lineare oder nichtlineare Funktion der abgetasteten und quantisierten momentanen Leistung des die nichtlinearen hochfrequenzseitigen Übertragungseinrichtungen durchlaufenden Übertragungssignals ist, daß das pulscodemodulierte Signal in einer digitalen Schaltung, die von einem Rechner, gesteuert durch einen Meßempfänger, einmalig oder adaptiv entsprechend den nichtlinearen Übertragungskennlinien der hochfrequenzseitigen Übertragungseinrichtungen bzw. entsprechend den von diesen verursachten nichtlinearen Verzerrungen programmiert wird, in ein geändertes pulscodemoduliertes Signal umgesetzt wird und daß das Übertragungssignal in der Nieder-, oder Zwischen-, oder Hochfrequenzebene als lineare oder nichtlineare Funktion des decodierten geänderten pulscodemodulierten Signals moduliert wird.

0131725

Dipl.-Ing. M. Horn
Europaplatz 6
D-7000 Stuttgart 80

HD E 09/83

Verfahren und Schaltungsanordnungen zur Kompensation von
nichtlinearen Amplituden- und/oder Phasenverzerrungen

Die Erfindung betrifft Verfahren zur Kompensation von
nichtlinearen Amplituden- und/oder Phasenverzerrungen nach
dem Oberbegriff des Anspruchs 1 und Schaltungsanordnungen
zu deren Durchführung.

Hochfrequenzseitige Übertragungseinrichtungen von Übertragungssystemen beinhalten auf der Sendeseite Frequenzumsetzer und Sendeverstärker sowie auf der Empfangsseite
Empfangsverstärker und Frequenzumsetzer. Diese Übertragungseinrichtungen besitzen die Eigenschaft, daß der
Betrag und die Phase des Quotienten aus der komplexen
Hüllkurve der Grundwelle ihres Ausgangssignals und der
komplexen Hüllkurve ihres Eingangssignals nichtlineare
Funktionen des Betrags der komplexen Hüllkurve bzw. der
momentanen Leistung ihres Eingangssignals sind. Dabei versteht man unter Grundwelle des Ausgangssignals das Signal,
das sich durch Nachschalten eines Bandpasses zur Unterdrückung der Frequenzbänder bei Harmonischen der Mittenfrequenz des Frequenzbandes des Übertragungssignals ergibt,
was bei hochfrequenzseitigen Übertragungseinrichtungen im
allgemeinen möglich ist, da sich deren Übertragungssignal
normalerweise über eine Bandbreite kleiner eine Oktave
erstreckt. Werden diese Übertragungseinrichtungen bei der
Übertragung von Signalen mit sich über der Zeit änderndem Betrag der komplexen Hüllkurve eingesetzt, so treten
aufgrund der genannten Eigenschaft von der Aussteuerung
abhängige nichtlineare Verzerrungen der Amplitude und der
Phase des Übertragungssignals ein, was zu einer von der

Aussteuerung abhängigen Übertragungsqualität sowie zu einer Änderung des Spektrums des Übertragungssignals führt. Im allgemeinen sinkt die Übertragungsqualität mit zunehmender Aussteuerung und das Spektrum des Übertragungssignals wird gleichzeitig verbreitert. Um Übertragungseinrichtungen mit der genannten Eigenschaft betreiben zu können, ohne die aus dieser Eigenschaft resultierenden Effekte in Kauf nehmen zu müssen, insbesondere bei Aussteuerung bis zur maximalen Ausgangsleistung, sind Verfahren anzuwenden, die eine exakte Kompensation der nichtlinearen Amplituden- und Phasenverzerrungen im gesamten Bereich des Betrags der komplexen Hüllkurve bzw. der momentanen Leistung des Übertragungssignals ermöglichen.

Es sind Verfahren zur Dämpfung von Intermodulationsprodukten bekannt, bei denen das Übertragungssignal im Übertragungssystem in einem Verzerrungsnetzwerk zusätzlich verzerrt wird, insbesondere vor den betreffenden nichtlinearen Übertragungseinrichtungen nach dem Prinzip der Signalvorverzerrung. Die Funktion des Verzerrungsnetzwerkes sollte sein, das Übertragungssignal so zu verzerren, daß die Reihenschaltung aus nichtlinearen Übertragungseinrichtungen und Verzerrungsnetzwerk bezüglich des Übertragungssignals insgesamt eine lineare Übertragungseinrichtung darstellt, wofür das Verzerrungsnetzwerk genau die durch die nichtlinearen Übertragungskennlinien der nichtlinearen Übertragungseinrichtungen vorbestimmten nichtlinearen Übertragungskennlinien besitzen müßte. Es hat sich jedoch gezeigt, daß sich bei den entsprechend den Verfahren zu verwendenden Verzerrungsnetzwerken diese notwendigen Übertragungskennlinien nur annähernd realisieren lassen, insbesondere bei einer angestrebten Aussteuerung der nichtlinearen Übertragungseinrichtungen bis zur maximalen Ausgangsleistung. Trotz dieser Näherung kann mit bestimmten Meßverfahren, wie zum Beispiel dem Zweitonverfahren, bei entsprechender Einstellung der Verzerrungsnetzwerke in einem gewissen Bereich der mittleren Leistung
des verwendeten Meßsignals eine starke Dämpfung der Intermodulationsprodukte erzielt werden, was auf eine Kompensation der nichtlinearen Verzerrungen schließen lassen
könnte. Tatsächlich erfolgt jedoch bei der Verwendung von
realen, zufälligen Signalen, insbesondere bei Aussteuerung
der nichtlinearen Übertragungseinrichtungen bis zur maximalen Ausgangsleistung, eine geringere Dämpfung der Intermodulationsprodukte, aufgrund der nur annähernd realisierbaren notwendigen nichtlinearen Übertragungskennlinien der
Vorverzerrungsnetzwerke und der daraus resultierenden, nur
bei einigen momentanen Amplituden des Übertragungssignals
wirklich genau erzielbaren Kompensation der nichtlinearen
Verzerrungen.

Der Erfindung liegt die Aufgabe zugrunde, Verfahren zu
schaffen, deren Durchführung es ermöglicht, nichtlineare
Amplituden- und/oder Phasenverzerrungen, die ein Übertragungssignal in nichtlinearen hochfrequenzseitigen Übertragungseinrichtungen eines Übertragungssystems erfährt,
insbesondere bei deren Aussteuerung bis zur maximalen
Ausgangsleistung, im gesamten Bereich der momentanen Amplitude des Übertragungssignals exakt zu kompensieren,
sowie wenig aufwendige und einfach auf die nichtlinearen
Übertragungseinrichtungen abzugleichende Schaltungsanordnungen zu deren Durchführung anzugeben.

Diese Aufgabe wird erfindungsgemäß mit den in den Patentansprüchen angegebenen Mitteln gelöst. Die Lösung der
Aufgabe, sowie die ihr zugrunde liegenden Überlegungen
sollen im Folgenden erläutert werden. Die hochfrequenzseitigen Übertragungseinrichtungen, deren nichtlineare
Amplituden- und Phasenverzerrungen kompensiert werden
sollen, ändern die momentane Amplitude und die momentane Phase des sie durchlaufenden Übertragungssignals als nichtlineare Funktion der momentanen Amplitude bzw. der momentanen Leistung des Übertragungssignals, d.h. einer bestimmten momentanen Amplitude bzw. momentanen Leistung kann eine bestimmte Änderung der momentanen Amplitude und der momentanen Phase zugeordnet werden. Die unerwünschten Änderungen können kompensiert werden, wenn im Übertragungssystem die momentane Amplitude und die momentane Phase des Übertragungssignals in genau definierter Weise als Funktion der momentanen Amplitude bzw. der momentanen Leistung des Übertragungssignals zusätzlich geändert werden, d.h. einer bestimmten momentanen Amplitude bzw. momentanen Leistung muß eine bestimmte zusätzliche Änderung der momentanen Amplitude und der momentanen Phase in entgegengesetzter Richtung zugeordnet werden. Soll die Kompensation bei allen vorkommenden momentanen Amplituden bzw. momentanen Leistungen des Übertragungssignals erfolgen, so müssen für alle diese Amplituden bzw. Leistungen die richtigen Zuordnungen erfolgen. Für die Kompensation benötigt man also vorallem Schaltungen, die Kenntnis über diese Zuordnungen besitzen, und die, wenn sie Aufschluß darüber erhalten, welche momentane Amplitude bzw. momentane Leistung das Übertragungssignal gerade besitzt, über die ihnen bekannten Zuordnungen die zusätzliche Änderung der momentanen Amplitude und der momentanen Phase des Übertragungssignals in die Wege leitet. Schaltungen, die dies für alle momentanen Amplituden bzw. momentanen Leistungen, also analog exakt bewerkstelligen können, sind praktisch nicht realisierbar. Wird jedoch der Bereich der momentanen Amplitude bzw. der momentanen Leistung in eine sehr große Anzahl von Unteramplituden- bzw. Leistungsbereichen unterteilt, quantisiert, dann sind Schaltungen realisierbar, denen die Kenntnis über die zu dieser eingeschränkten Anzahl von Unteramplituden- bzw. Leistungsbereichen gehörenden Zuordnungen exakt beigebracht werden können. Diese Schaltungen werden erfindungsgemäß mit digitalen Schaltungen realisiert, zum Beispiel
mit adressierbaren Speichern, bei denen eine Zuordnung
zwischen den gespeicherten Daten und den zugehörigen
Adressen gegeben ist, wobei die oben erwähnte wertdiskrete Signalverarbeitung zur wert- und zeitdiskreten
Signalverarbeitung ausgeweitet wird. Dabei ist zu beachten, daß die zeitdiskrete Verarbeitung bei Einhaltung des
Abtasttheorems keine Abstriche an die Verarbeitungsqualität mit sich bringt, während bei der wertdiskreten Verarbeitung die mit abnehmender Anzahl der Quantisierungsstufen zunehmenden Quantisierungsverzerrungen in Betracht
gezogen werden müssen.

Aus dem Erfindungsgedanken, digitale Schaltungen zu verwenden bei der Realisierung der für eine Kompensation der
nichtlinearen Amplituden- und Phasenverzerrungen notwendigerweise einzusetzenden nichtlinearen Schaltungen,
welche für eine exakte Kompensation genau die durch die
nichtlinearen Übertragungskennlinien der hochfrequenzseitigen Übertragungseinrichtungen vorbestimmten nichtlinearen Übertragungskennlinien besitzen müssen, resultieren
erfindungsgemäß zwei Verfahren mit verschiedenen Ausgestaltungsmöglichkeiten und Schaltungsanordnungen zur
Durchführung der Verfahren. Beim ersten Verfahren wird
im Übertragungssystem vor oder nach den nichtlinearen
hochfrequenzseitigen Übertragungseinrichtungen aus dem
Übertragungssignal in der Nieder- Zwischen- oder Hochfrequenzebene ein pulscodemoduliertes Signal abgeleitet,
dessen analoges Abbild eine lineare oder nichtlineare
Funktion des Betrags der komplexen Hüllkurve bzw. der
momentanen Leistung des die nichtlinearen hochfrequenzseitgen Übertragungseinrichtungen durchlaufenden Übertragungssignals ist. Eine nichtlineare Funktion ist
möglich, da auch diese bei der Programmierung der

0131725

digitalen Schaltungen berücksichtigt werden kann. Das pulscodemodulierte Signal wird in einer digitalen Schaltung, die manuell oder durch einen Rechner einmalig oder adaptiv, gesteuert durch einen Meßempfänger, entsprechend den nichtlinearen Übertragungskennlinien der betreffenden hochfrequenzseitigen Übertragungseinrichtungen, bzw. entsprechend den von diesen verursachten nichtlinearen Amplituden- und Phasenverzerrungen programmiert ist, in ein geändertes pulscodemoduliertes Signal umgesetzt. Schließlich wird das Übertragungssignal als lineare oder nichtlineare Funktion des analogen Abbilds des geänderten pulscodemodulierten Signals in der Nieder-, Zwischen-, oder Hochfrequenzebene moduliert. Auch hier ist wieder eine nichtlineare Funktion möglich, da auch diese bei der Programmierung der digitalen Schaltungen berücksichtigt werden kann. Beim zweiten Verfahren wird nicht der Umweg der digitalen Verarbeitung des Betrags der komplexen Hüllkurve bzw. der momentanen Leistung mit nachfolgender Modulation des Übertragungssignals beschritten, was im allgemeinen die Verwendung von digitalen Schaltungen für niederere Takt- und Bitraten erlaubt, sondern es wird eine direkte digitale Verarbeitung des Übertragungssignals vorgenommen. Es wird im Übertragungssystem vor oder nach den nichtlinearen hochfrequenzseitigen Übertragungseinrichtungen aus dem Übertragungssignal in der Nieder-, Zwischen-, oder Hochfrequenzebene ein pulscodemoduliertes Signal abgeleitet, dessen analoges Abbild eine lineare oder nichtlineare Funktion des Übertragungssignals ist. Dieses pulscodemodulierte Signal wird in einer digitalen Schaltung, die manuell oder durch einen Rechner einmalig oder adaptiv, gesteuert durch einen Meßempfänger, entsprechend den nichtlinearen Übertragungskennlinien der betreffenden hochfrequenzseitigen Übertragungseinrichtungen, bzw. entsprechend den von diesen verursachten nichtlinearen Amplituden- und Phasenverzerrungen programmiert ist, in ein geändertes pulscodemoduliertes Signal umgesetzt. Schließlich wird das Übertragungssignal durch ein Signal ersetzt oder dem Übertragungssignal wird dieses Signal aufaddiert, das eine lineare oder nichtlineare Funktion des analogen Abbilds des geänderten pulscodemodulierten Signals ist. Bei der Anwendung der Verfahren auf Übertragungssysteme, bei denen das Übertragungssignal durch mehrere parallel laufende Teilübertragungssignale repräsentiert wird, was bei bestimmten Systemen insbesondere in der Niederfrequenzebene der Fall sein kann, wie zum Beispiel in Systemen mit Quadraturamplitudenmodulation, ist der bei der Beschreibung der Verfahren verwendete Begriff des Übertragungssignals entsprechend auszulegen. Zum Beispiel hat also bei der Anwendung der Verfahren in der Niederfrequenzebene eines Übertragungssystems mit Quadraturamplitudenmodulation die Ableitung des pulscodemodulierten Signals unter Einbeziehung beider Teilübertragungssignale, also der Normal- und der Quadraturkomponente zu geschehen, wie auch beim ersten Verfahren die Modulation auf beide Komponenten anzuwenden sein wird bzw. beim zweiten Verfahren zwei geänderte pulscodemodulierte Teilsignale zur Bildung der zwei geänderten Komponenten erzeugt werden müssen. Die Verfahren wurden zur Kompensation von in nichtlinearen hochfrequenzseitigen Übertragungseinrichtungen hervorgerufenen nichtlinearen Verzerrungen des Übertragungssignals entwickelt, können natürlich aber auch verwendet werden, um in anderen nichtlinearen Übertragungseinrichtungen des Übertragungssystems hervorgerufene nichtlineare Verzerrungen ganz oder teilweise gleich mitzukompensieren oder auch getrennt zu kompensieren oder verwendet werden, um Übertragungssignale bewußt in defierter exakt zu verzerren. Die angegebenen Schaltungsanordnungen zur Durchführung der Verfahren sind nur ein Teil der möglichen Schaltungsanordnungen. Weitere erhält man unschwer unter Beachtung der der Erfindung zugrunde liegenden Überlegungen durch Kombination von Teilschaltungsanordnungen der angegebenen Schaltungsanordnungen zu Schaltungsanordnungen, die zum Beispiel zum Teil im niederfrequenten und zum Teil im zwischenfrequenten und/oder hochfrequenten Signalweg liegen. In den Schaltungsanordnungen angegebene Reihenschaltungen sind nicht streng als solche zu verstehen. Es können innerhalb einer Reihe Schaltungsteile an anderer Stelle liegen oder weitere Baugruppen wie Verstärker, Dämpfungsglieder, Laufzeitausgleichsglieder oder Frequenzumsetzer eingefügt sein, wenn damit die prinzipielle Funktion der Schaltungsanordnungen nicht verändert wird. Bei den in den Schaltungsanordnungen verwendeten digitalen Schaltungen kann es sich um Schaltungen mit serieller oder paralleler Ein-/Ausgabe handeln. Im parallelen Fall besteht dann ein Ein-/Ausgang aus parallelen Teilein-/ausgängen. Sind digitale Schaltungen mit unterschiedlicher Ein-/Ausgabe hintereinandergeschaltet, so sind Wandler von Serie auf Parallel oder umgekehrt zwischengeschaltet. Zu taktende digitale Schaltungen sind, gegebenenfalls über Verzweigungsschaltungen und Laufzeitausgleichsglieder an einen Taktgenerator angeschlossen, dessen Frequenz des Taktsignals so eingestellt ist, daß Aliasing vermieden wird.

In den Zeichnungen sind vereinfachte Blockschaltbilder von beanspruchten Schaltungsanordnungen sowie ausführliche Blockschaltbilder zu drei nachfolgend beschriebenen Ausführungsbeispielen dargestellt.

Es zeigen

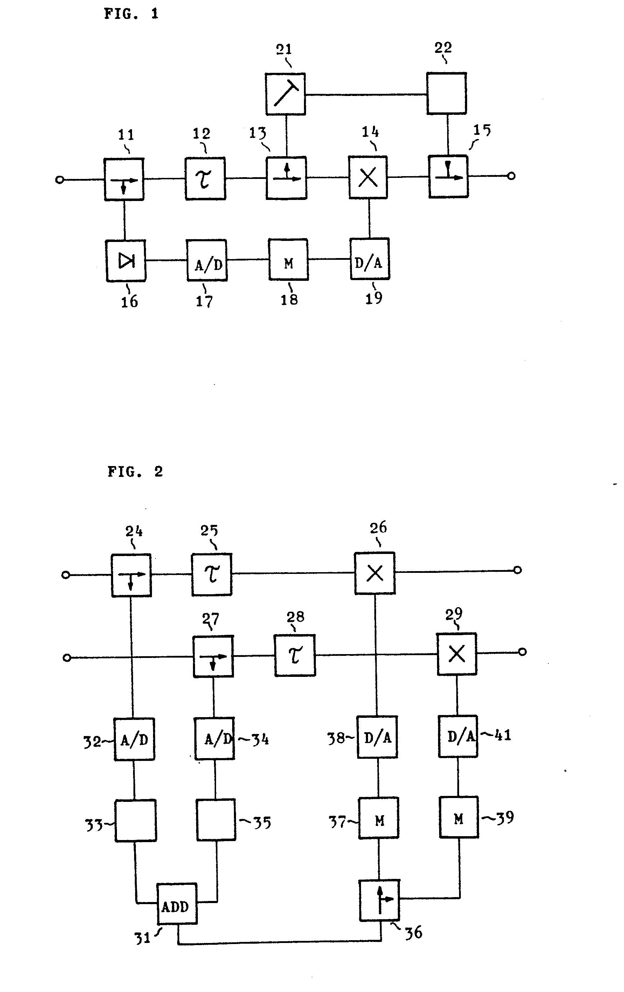

Fig. 1     ein Blockschaltbild der Schaltungsanordnung
           nach Anspruch 12 oder Unteransprüchen

Fig. 2        ein Blockschaltbild der Schaltungsanordnung
             nach Anspruch 14 oder Unteransprüchen

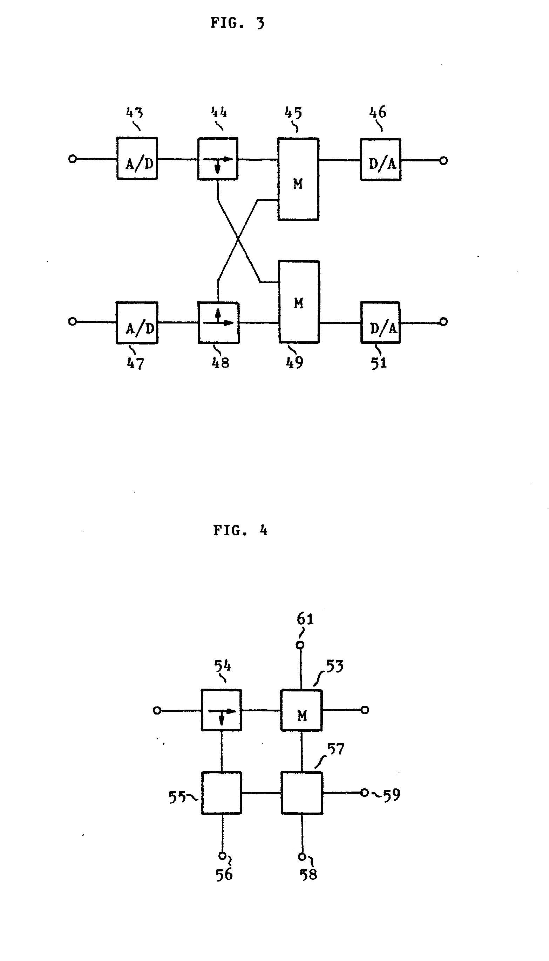

Fig. 3        ein Blockschaltbild der Schaltungsanordnung
             nach Anspruch 18 oder Unteransprüchen

Fig. 4        ein Blockschaltbild der Schaltungsanordnung
             nach Anspruch 22 oder Unteransprüchen

Fig. 5        ein Blockschaltbild des ersten Ausführungsbeispiels

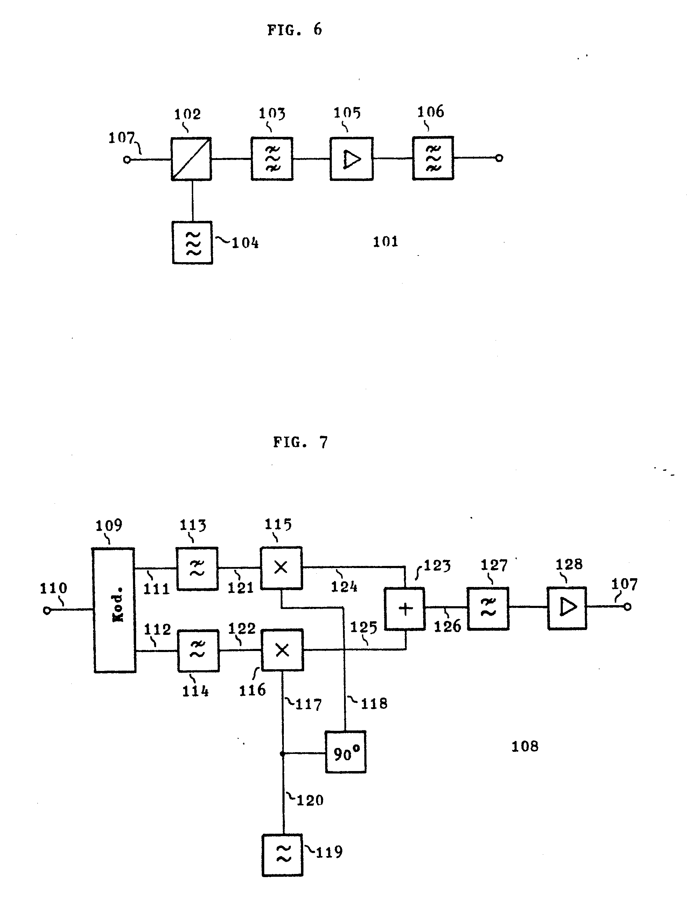

Fig. 6        ein Blockschaltbild eines Mikrowellensenders

Fig. 7        ein Blockschaltbild eines QAM-Modulators

Fig. 8        ein Blockschaltbild eines QAM-Modulators mit
             Schaltungsanordnung zur Kompensation der nichtlinearen Amplituden- und Phasenverzerrungen
             des Mikrowellensenders

Fig. 9        ein Blockschaltbild des dritten Ausführungsbeispiels

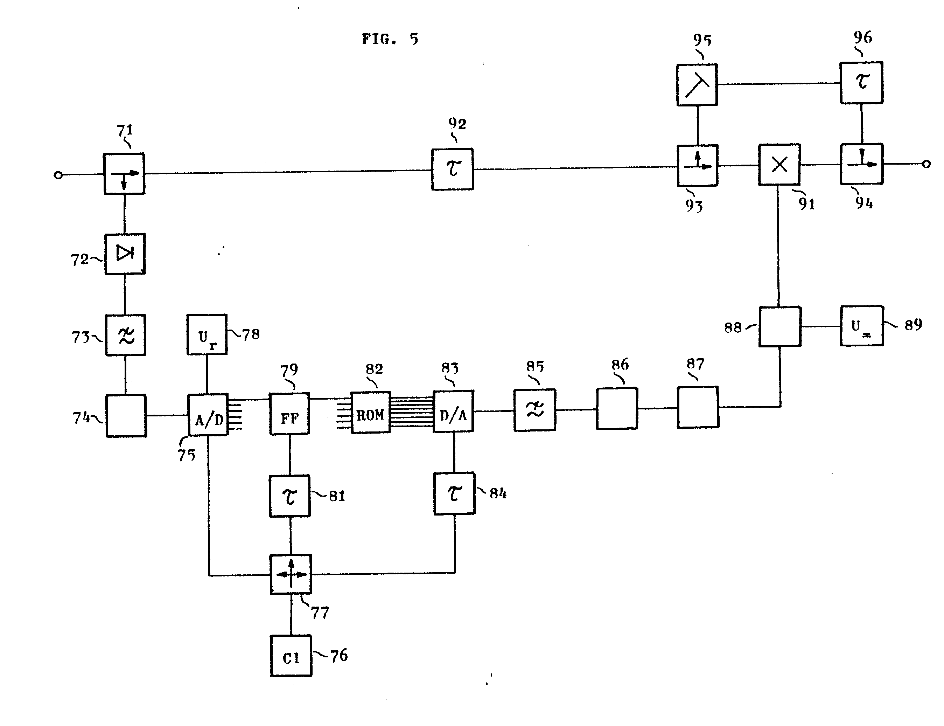

Ein erstes Ausführungsbeispiel der Erfindung ist in Fig. 5 der Zeichnungen dargestellt und wird im Folgenden näher beschrieben.

Zur Kompensation der nichtlinearen Amplituden- und Phasenverzerrungen in einem Richtfunkübertragungssystem, insbesondere der nichtlinearen Verzerrungen des Mikrowellensenders, der im Wesentlichen besteht aus einem Frequenzumsetzer von der Zwischenfrequenz- in die Hochfrequenzebene, einem Bandpass, einem Umsetzoszillator und einem Leistungsverstärker, bestückt mit einer Wanderfeldröhre, ist in den zwischenfrequenten Signalweg vor dem Frequenzumsetzer ein erster Leistungsteiler (71) eingebaut, der über seinen zweiten Abzweig einen Teil des zwischenfrequenten Signals einem Gleichrichter (72) zuführt, der einen linearen Amplituden- und Phasengang bezüglich der Hüllkurve des zwischenfrequenten Signals besitzt. Das Ausgangssignal des Gleichrichters (72) wird einem ersten Tiefpaß (73) zur Unterdrückung der außerhalb des Frequenzbandes der Hüll-

0131725

kurve liegenden Frequenzanteile zugeführt. Der erste Tiefpaß (73) besitzt im Durchlaßbereich einen linearen Amplitudengang, sein nichtlinearer Phasengang wird in einem nachgeschalteten ersten Allpaß (74) entzerrt. Das Ausgangssignal des ersten Allpasses (74) wird auf einen Analog-Digital-Wandler (75) gegeben. Dieser besitzt eine Analogbandbreite, die größer ist als die Bandbreite der Hüllkurve des zwischenfrequenten Signals, eine Auflösung von sechs Bit und wird durch ein von einem Taktgenerator (76) über eine Dreiwegverzweigungsschaltung (77) abgegebenes Taktsignal getaktet, dessen Frequenz etwa das Dreifache der Bandbreite der Hüllkurve des zwischenfrequenten Signals ist. Die von einer Referenzspannungsquelle (78) an den Analog-Digital-Wandler (75) angelegte positive bzw. negative Referenzgleichspannung ist gleich dem positiven bzw. negativen maximalen Momentanwert des Ausgangssignals des ersten Allpasses (74). Jedem der sechs parallelen Ausgänge des Analog-Digital-Wandlers (75) ist jeweils ein Flip-Flop (79) zur Impulsformung nachgeschaltet. Ihr Taktsignal erhalten die Flip-Flops (79) über die Dreiwegverzweigungsschaltung (77) und eine erste Verzögerungsleitung (81) ebenfalls aus dem Taktgenerator (76). Die erste Verzögerungsleitung (81) ist so eingestellt, daß die Übernahme in die Flip-Flops (79) bei der größten Augenöffnung der Ausgangssignale des Analog-Digital-Wandlers (75) erfolgt. Die Ausgänge der Flip-Flops (79) liegen an den sechs parallelen Adresseingängen eines 64x8 Bit- Festwertspeichers (82). Die acht parallelen Ausgänge des Festwertspeichers (82) sind mit den acht parallelen Eingängen eines Digital-Analog-Wandlers (83) verbunden, der sein Taktsignal ebenfalls aus dem Taktgenerator (76) über die Dreiwegverzweigungsschaltung (77) und eine zweite Verzögerungsleitung (84) erhält. Die zweite Verzögerungsleitung (84) ist so eingestellt, daß die Übernahme in den Digital-Analog-Wandler (83) in der Mitte der Augenöffnung der Ausgangssignale des Festwertspeichers (82) erfolgt. Die Analogbandbreite

des Digital-Analog-Wandlers (83) ist größer als die halbe Taktfrequenz. An den Ausgang des Digital-Analog-Wandlers (83) ist ein zweiter Tiefpaß (85) mit steiler Flanke und mit einer Sperrfrequenz von etwa der Hälfte der Taktfrequenz angeschlossen, zur Unterdrückung der Frequenzbänder bei Harmonischen der Taktfrequenz. Dem zweiten Tiefpaß (85) ist ein Amplitudengangentzerrer (86) nachgeschaltet, der den Amplitudengang der Reihenschaltung aus Digital-Analog-Wandler (83) und zweitem Tiefpaß (85) entzerrt, und dabei vorallem die sin x/x-Bewertung des Spektrums des Ausgangssignals des Digital-Analog-Wandlers (83) kompensiert, die dadurch vorhanden ist, daß der abgegebene modulierte Puls aus annähernd rechteckförmigen Impulsen besteht. Das Ausgangssignal des Amplitudengangentzerrers (86) wird auf einen zweiten Allpaß (87) zur Entzerrung des Phasengangs der Reihenschaltung aus Digital-Analog-Wandler (83), zweitem Tiefpaß (85) und Amplitudengangentzerrer (86) gegeben. Das Ausgangssignal des zweiten Allpasses (87) wird zusammen mit einer in einem Bias-Tee (88) überlagerten Gleichspannung, die von einer einstellbaren Gleichspannungsquelle (89) geliefert wird, dem zweiten Eingang eines Vierquadrantenmultiplizierers (91) zugeführt. Die Gleichspannung dient zur Arbeitspunkteinstellung des Multiplizierers (91). Die Bandbreite des zweiten Eingangs des Multiplizierers (91) ist größer als die halbe Taktfrequenz. Er besitzt bezüglich des zweiten Eingangs einen linearen Amplituden- und Phasengang. Seine Dynamik beträgt vom Arbeitspunkt ausgehend etwa 10 dB. Der Multiplizierer (91) ist mit seinem ersten Eingang und seinem Ausgang, dem ersten Leistungsteiler (71) nachfolgend, in den zwischenfrequenten Signalweg eingeschleift. Die Bandbreite des ersten Eingangs ist größer als die Bandbreite des zwischenfrequenten Signals. Zwischen dem ersten Abzweig des ersten Leistungsteilers (71) und dem ersten Eingang des Multiplizierers (91) ist außerdem in den zwischenfrequenten Signalweg eine dritte Verzögerungsleitung (92) und ein zweiter Leistungsteiler (93) mit seinem Eingang und seinem ersten Abzweig, sowie, dem Multiplizierer (91) nachfolgend, ein Leistungsaddierer (94) mit seinem ersten Eingang und seinem Ausgang eingeschleift. Die dritte Verzögerungsleitung (92) ist so eingestellt, daß zwischen dem ersten Abzweig des ersten Leistungsteilers (71) und dem ersten Eingang des Multiplizierers (91) die gleiche Laufzeit besteht wie zwischen dem zweiten Abzweig des ersten Leistungsteilers (71) und dem zweiten Eingang des Multiplizierers (91). Der zweite Leistungsteiler (93) teilt das zwischenfrequente Signal so auf, daß zwischen dem Ausgangssignal am zweiten Abzweig und dem am ersten Abzweig eine Phasenbeziehung von 90° besteht. Der zweite Abzweig des zweiten Leistungsteilers (93) ist mit dem zweiten Eingang des Leistungsaddierers (94) über eine Reihenschaltung aus einem Dämpfungsglied (95) und einer vierten Verzögerungsleitung (96) verbunden. Die vierte Verzögerungsleitung (96) ist so eingestellt, daß zwischen dem zweiten Abzweig des zweiten Leistungsteilers (93) und dem zweiten Eingang des Leistungsaddierers (94) die gleiche Laufzeit besteht, wie zwischen dem ersten Abzweig des zweiten Leistungsteilers (93) und dem ersten Eingang des Leitungsaddierers (94).

Die Anpassung der beschriebenen Schaltungsanordnung an die nichtlinearen Übertragungseinrichtungen, deren nichtlineare Verzerrungen kompensiert werden sollen, erfolgt durch Einsatz eines Festwertspeichers (82) mit entsprechender Programmierung sowie durch entsprechende Einstellung des Dämpfungsgliedes (95). Die Ermittlung der optimalen Programmierung und Einstellung erfolgt anhand einer nach Anspruch 14 oder 15 abgewandelten Schaltungsanordnung anstelle der beschriebenen Schaltungsanordnung, die dieser mit der Ausnahme entspricht, daß der Festwertspeicher (82) durch einen Schreib-Lese-Speicher ersetzt ist, dessen gespeicherte Daten während des Betriebs der Schaltungsanordnung manuell oder durch einen Rechner verstellt werden können. Für den Grobabgleich der abgewandelten Schaltungsanordnung werden für jede Quantisierungsstufe des Analog-Digital-Wandlers (75) Stufe für Stufe die im Schreib-Lese-Speicher gespeicherten Daten solange verstellt, bis ein von einem Meßempfänger geliefertes Fehlersignal bei allen Stufen minimiert ist. Der Meßempfänger vergleicht die Signale vor und nach der Reihenschaltung aus der abgewandelten Schaltungsanordnung und den die nichtlinearen Verzerrungen verursachenden Übertragungseinrichtungen und leitet daraus das Fehlersignal ab. Das Dämpfungsglied (95) wird dabei so eingestellt, daß sich bei Programmierung des Schreib-Lese-Speichers auf optimale Kompensation der Amplitudenverzerrungen gleichzeitig die beste Kompensation der Phasenverzerrungen oder umgekehrt ergibt. Anschließend kann noch ein Feinabgleich der im Schreib-Lese-Speicher gespeicherten Daten sowie des Dämpfungsgliedes auf Minimierung des Intermodulationsgeräusches in analogen Systemen oder der Fehlerrate in digitalen Systemen vorgenommen werden. Schließlich werden die im Schreib-Lese-Speicher abgespeicherten optimalen Daten in einen entsprechenden Festwertspeicher abgespeichert, der als Festwertspeicher (82) in die beschriebene Schaltungsanordnung eingesetzt wird, deren Dämpfungsglied (95) auf die gleiche Dämpfung eingestellt wird, wie das der abgewandelten Schaltungsanordnung.

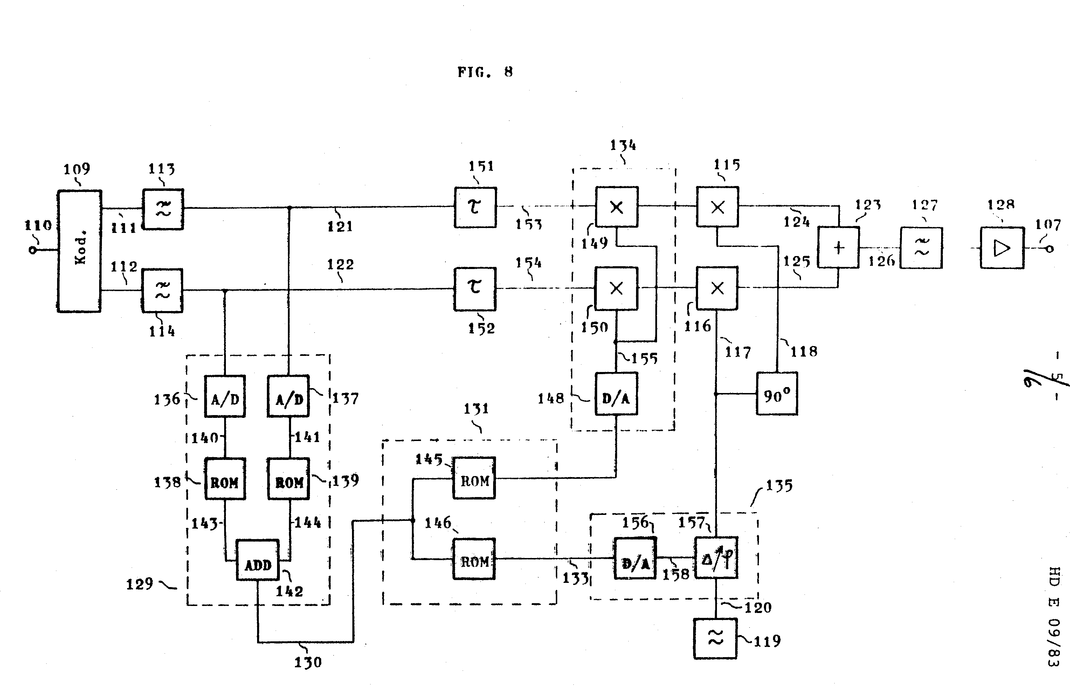

Ein zweites Ausführungsbeispiel der Erfindung ist in Fig. 8 der Zeichnungen dargestellt und wird im Folgenden näher beschrieben.

Es wird eine Schaltungsanordnung zur Kompensation der nichtlinearen Amplituden- und Phasenverzerrungen eines Mikrowellensenders (101), der in einem Übertragungssystem zur Übertragung eines Quadratur-Amplituden-modulierten (QAM) Signals, zum Beispiel eines 16-QAM Signals, eingesetzt wird, vorgestellt.

Der Mikrowellensender (101) besteht im Wesentlichen aus einem Frequenzumsetzer (102), der das angelieferte QAM-Signal (107) aus der Zwischenfrequenzebene in die Hochfrequenzebene umsetzt, einem Bandpass (103), der die unerwünschten Mischprodukte unterdrückt, einem den Frequenzumsetzer (102) steuernden Umsetzoszillator (104) und einem Wanderfeldröhrenleistungsverstärker (105) mit nachgeschaltetem Bandpass (106).

Das QAM-Zwischenfrequenzsignal (107) wird in einem QAM-Modulator (108) aufbereitet. Dieser besteht aus einem Kodierer (109), der aus dem zu übertragenden Datenstrom (110) zwei hartgetastete Basisbandsignale (111) und (112) bildet, zwei Tiefpässen (113) und (114), die die Impulsformung der Normal- und Quadraturkomponente des QAM-Signals im Basisband vornehmen, zwei Produktmodulatoren (115) und (116), in denen die Normalkomponente (117) und die Quadraturkomponente (118) der von einem Trägergenerator (119) gelieferten Trägerschwingung (120) mit den gefilterten Basisbandsignalen (121) und (122) in der Amplitude moduliert werden, sowie aus einem Summierer (123), in dem die amplitudenmodulierten Komponenten (124) und (125) der Trägerschwingung (120) zum Summensignal (126) zusammengefaßt werden, sowie aus einem Tiefpaß (127) zur Unterdrückung unerwünschter Mischprodukte und einem nachgeschalteten Zwischenfrequenzverstärker (128).

Die Schaltungsanordnung zur Kompensation der nichtlinearen Amplituden- und Phasenverzerrungen des Mikrowellensenders (101) ist in den QAM-Modulator (108) eingesetzt. Sie besteht aus einer Erkennungsschaltung (129), die ein pulscodemoduliertes Kennsignal (130) abgibt, das in codierter Form eine Funktion der abgetasteten und quantisierten momentanen Leistung des den Mikrowellensender (101) durchlaufenden QAM-Signals ist, zwei digitalen Umsetzern (131), die das von der Erkennungsschaltung (129) abgegebene pulscodemodulierte Kennsignal (130) in zwei pulscodemodulierte

0131725.

Korrektursignale (132) und (133) umsetzen, wobei jedem Codewort des pulscodemodulierten Kennsignals (130) ein entsprechend der nichtlinearen Amplitudenkennlinie des Mikrowellensenders (101) vorbestimmtes Codewort des pulscodemodulierten Korrektursignals (132) und ein entsprechend der nichtlinearen Phasenkennlinie des Mikrowellensenders (101) vorbestimmtes Codewort des pulscodemodulierten Korrektursignals (133) zugeordnet wird, sowie aus einer Amplitudenkorrekturschaltung (134), in der die beiden gefilterten Basisbandsignale (121) und (122) gleichartig als Funktion des vom digitalen Umsetzer (131) abgegebenen decodierten pulscodemodulierten Korrektursignals (132) verstärkt oder gedämpft werden, wodurch die Amplitude des den Mikrowellensender (101) durchlaufenden QAM-Signals ebenfalls als Funktion des decodierten pulscodemodulierten Korrektursignals (132) geändert wird, sowie aus einer Phasenkorrekturschaltung (135), mit der die Phase der vom Trägergenerator (119) gelieferten Trägerschwingung (120) und damit auch die momentane Phase des den Mikrowellensender (101) durchlaufenden QAM-Signals als Funktion des vom digitalen Umsetzer (131) abgegebenen decodierten pulscodemodulierten Korrektursignals (133) geändert wird.

Die Erkennungsschaltung (129) besteht aus zwei A/D-Wandlern (136) und (137), in denen die gefilterten Basisbandsignale (121) und (122) abgetastet, quantisiert und codiert, also in pulscodemodulierte Signale umgewandelt werden, zwei Festwertspeichern (138) und (139), in denen die digitalen Ausgangssignale (140) und (141) der A/D-Wandler (136) und (137) digital quadriert werden, dadurch, daß die digitalen Ausgangssignale (140) und (141) der A/D-Wandler (136) und (137) an die Festwertspeicher (138) und (139) als Adresssignale angelegt werden und dadurch, daß unter den einzelnen Adressen der Speicher als Daten das digitale Quadrat der Adressen abgespeichert ist und den

0131725

angelegten Adressen entsprechend ausgelesen wird, sowie aus einem Addierer (142), in dem die Ausgangssignale (143) und (144) der Festwertspeicher (138) und (139) digital addiert werden. Das pulscodemodulierte Ausgangssignal des Addierers (142) stellt das Ausgangssignal der Erkennungsschaltung (129), das pulscodemodulierte Kennsignal (130) dar und ist in codierter Form eine Funktion der Summe der Quadrate der abgetasteten und quantisierten gefilterten Basisbandsignale (121) und (122) und damit in codierter Form eine Funktion der abgetasteten und quantisierten momentanen Leistung des den Mikrowellensender (101) durchlaufenden QAM-Signals.

Die digitalen Umsetzer (131) bestehen aus Festwertspeichern (145) und (146), an die das von der Erkennungsschaltung (129) abgegebene pulscodemodulierte Kennsignal (130) als Adressignal angelegt wird. Die Speicher lesen die unter den einzelnen Adressen gespeicherten Daten aus, die die Ausgangssignale der beiden digitalen Umsetzer (131), die pulscodemodulierten Korrektursignale (132) und (133) bilden. Im Festwertspeicher (145) sind die Daten abgespeichert, die zur einer optimalen Kompensation der nichtlinearen Amplitudenverzerrungen und im Festwertspeicher (146) diejenigen Daten, die zu einer optimalen Kompensation der nichtlinearen Phasenverzerrungen des Mikrowellensenders (101) führen. Die Ermittlung der optimalen Programmierung erfolgt unter Verwendung von Schreib-Lese-Speichern anstatt der Festwertspeicher (145) und (146) und unter Verwendung eines Meßempfängers, manuell oder durch einen Rechner, wie im ersten Ausführungsbeispiel beschrieben.

Die Amplitudenkorrekturschaltung (134) besteht aus einem D/A-Wandler (148), in dem das vom digitalen Umsetzer (131) abgegebene pulscodemodulierte Korrektursignal (132) analogisiert wird, und zwei identischen Vierquadrantenmultiplizierern (149) und (150), in denen die gefilterten und über die Verzögerungsleitungen (151) und (152) verzögerten Basisbandsignale (153) und (154) mit dem Ausgangssignal (155) des D/A-Wandlers (148) multipliziert werden.

Die Phasenkorrekturschaltung (135) besteht aus einem D/A-Wandler (156), in dem das vom digitalen Umsetzer (131) abgegebene pulscodemodulierte Korrektursignal (133) analogisiert wird und einem Phasenmodulator (157), mit dem die vom Trägergenerator (119) gelieferte Trägerschwingung (120) mit dem Ausgangssignal (158) des D/A-Wandlers (156) in der Phase moduliert wird.

Die Wandlung in den A/D-Wandlern (136) und (137) der Erkennungsschaltung (129) und in den D/A-Wandlern (148) und (156) der Amplitudenkorrekturschaltung (134) und der Phasenkorrekturschaltung (135) hat mit einem Takt zu erfolgen, dessen Frequenz entsprechend dem Abtasttheorem mindestens doppelt so hoch ist, wie die Bandbreite der Ausgangssignale (155) und (158) der D/A-Wandler (148) und (156), wenn Verfälschungen dieser Signale durch Aliasing ausgeschlossen werden sollen. Die übrigen digitalen Bausteine sind ebenfalls entsprechend dieser Taktfrequenz auszuwählen. Die Vierquadrantenmultiplizierer (149) und (150) der Amplitudenkorrekturschaltung (134) und der Phasenmodulator (157) der Phasenkorrekturschaltung (135) sind so auszuwählen, daß sie in der Lage sind, die Bandbreite der Ausgangssignale (155) und (158) der D/A-Wandler (148) und (156) zu verarbeiten. Es ist weiterhin zu beachten, daß natürlich die Genauigkeit der Kompensation von der Länge der in der Schaltungsanordnung verarbeiteten pulscodemodulierten Worte abhängt. Je feiner der vorkommende Leistungsbereich quantisiert wird, desto genauer die Kompensation. Die Verarbeitung von Worten mit einer Länge von nur sechs Bit reicht jedoch im allgemeinen aus um eine sehr gute Kompensation zu erzielen. Die Basisbandsignale (121) und (122) müssen mit den Verzögerungsleitungen (151) und (152) exakt um die Laufzeit der Erkennungsschaltung (129), der digitalen Umsetzer (131) und der D/A-Wandler (148) und (156) der Amplitudenkorrekturschaltung (134) und der Phasenkorrekturschaltung (135) verzögert werden.

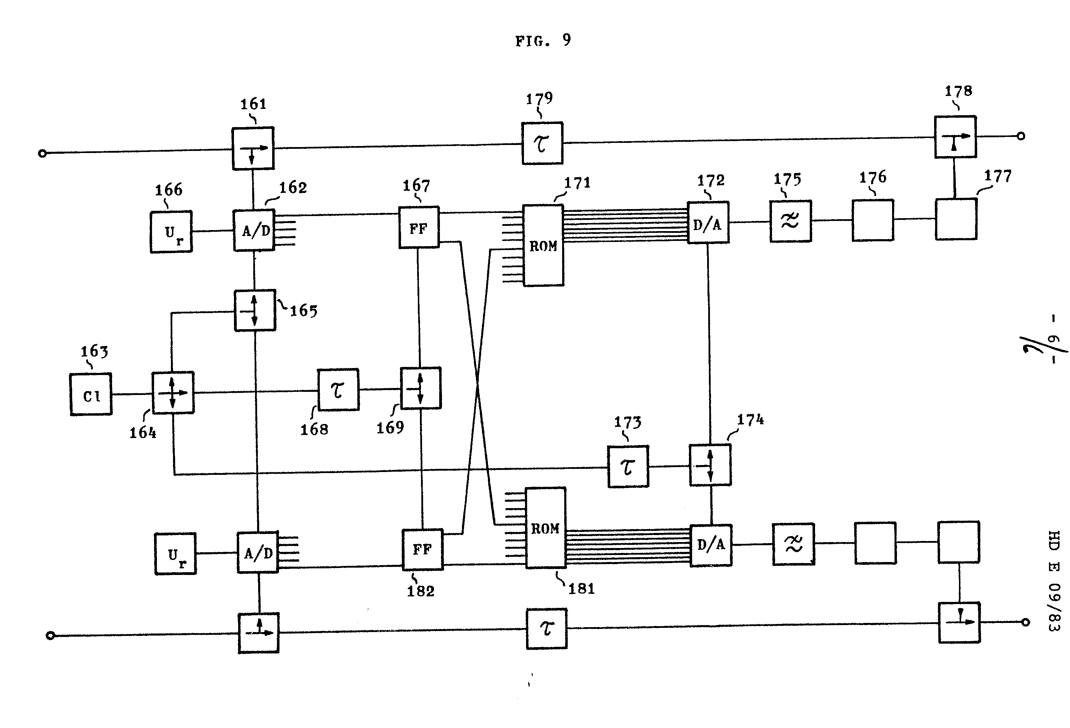

Ein drittes Ausführungsbeispiel der Erfindung ist in Fig. 9 der Zeichnungen dargestellt und wird im Folgenden näher beschrieben.

Für das im zweiten Ausführungsbeispiel beschriebene Übertragungssystem mit Quadraturamplitudenmodulation wird eine weitere Schaltungsanordnung zur Kompensation der nichtlinearen Amplituden- und Phasenverzerrungen des Mikrowellensenders (101) vorgestellt, die innerhalb des QAM-Modulators (108) in den niederfrequenten Weg der Normal- bzw. Quadraturkomponente zwischen dem Tiefpaß (113) bzw. (114) und dem Produktmodulator (115) bzw. (116) eingeschleift ist.

In der ersten, die Normalkomponente betreffenden Hälfte der symetrischen Schaltungsanordnung führt ein Leistungsteiler (161) über seinen zweiten Abzweig einen Teil der Normalkomponente einem A/D-Wandler (162) zu. Dieser besitzt eine Analogbandbreite, die größer ist als die Bandbreite der Normalkomponente, eine Auflösung von fünf Bit und wird durch ein von einem Taktgenerator (163) über eine Dreiwegverzweigungsschaltung (164) und eine erste Zweiwegverzweigungsschaltung (165) abgegebenes Taktsignal getaktet, dessen Frequenz etwa das Vierfache der Bandbreite der Normalkomponente ist. Die von einer Referenzspannungsquelle (166) an den A/D-Wandler (162) angelegte positive bzw. negative Referenzgleichspannung ist gleich dem positiven bzw. negativen maximalen Momentanwert der Normalkomponente am Eingang des A/D-Wandlers (162). Jedem der fünf parallelen Ausgänge des A/D-Wandlers (162) ist jeweils ein Flip-Flop (167) zur Impulsformung nachgeschaltet, das zwei Ausgänge besitzt, einen negierten und einen unnegierten. Ihr Taktsignal erhalten die Flip-Flops (167) über die Dreiwegverzweigungsschaltung (164), eine erste Verzögerungsleitung (168) und eine zweite Zweiwegverzweigungsschaltung (169) ebenfalls aus dem Taktgenerator (163). Die erste Verzögerungsleitung (168) ist so eingestellt, daß die Übernahme in die Flip-Flops (167) bei der größten Augenöffnung der Ausgangssignale des A/D-Wandlers (162) erfolgt. Die unnegierten Ausgänge der Flip-Flops (167) sind mit den ersten fünf von zehn parallelen Adresseingängen eines 1024x8 Bit Festwertspeichers (171) verbunden. Die acht parallelen Ausgänge des Festwertspeichers (171) sind mit den acht parallelen Eingängen eines D/A-Wandlers (172) verbunden, der sein Taktsignal ebenfalls aus dem Taktgenerator (163) über die Dreiwegverzweigungsschaltung (164) sowie über eine zweite Verzögerungsleitung (173) und eine dritte Zweiwegverzweigungsschaltung (174) erhält. Die zweite Verzögerungsleitung (173) ist so eingestellt, daß die Übernahme in den D/A-Wandler (172) in der Mitte der Augenöffnung der Ausgangssignale des Festwertspeichers (171) erfolgt. Die Analogbandbreite des D/A-Wandlers (172) ist größer als die halbe Taktfrequenz. Der Ausgang des D/A-Wandlers (172) ist mit einem Tiefpaß (175) mit steiler Flanke und einer Sperrfrequenz von etwa der Hälfte der Taktfrequenz verbunden, zur Unterdrückung der Frequenzbänder bei Harmonischen der Taktfrequenz. Dem Tiefpaß (175) ist ein Amplitudengangentzerrer (176) nachgeschaltet, der den Amplitudengang der Reihenschaltung aus D/A-Wandler (172) und Tiefpaß (175) entzerrt, und dabei vorallem die sin x/x-Bewertung des Spektrums des Ausgangssignals des D/A-Wandlers (172) kompensiert, die dadurch vorhanden ist, daß der abgegebene modulierte Puls aus annähernd rechteckförmigen Impulsen besteht. Das Ausgangssignal des Amplitudengangentzerrers (176) wird auf einen Allpaß (177) zur Entzerrung des Phasengangs der Reihenschaltung aus D/A-Wandler (172), Tiefpaß (175) und Amplitudengangentzerrer (176) gegeben. Das Ausgangssignal des Allpasses (177) wird dem zweiten Eingang eines Leistungsaddierers (178) zugeführt, in dem es der Normalkomponente aufaddiert wird, die dem ersten Eingang des Leistungsaddierers (178) über eine mit dem ersten Abzweig des Leistungsteilers (161) verbundene dritte Verzögerungsleitung (179) zugeführt wird. Die dritte Verzögerungsleitung (179) ist so eingestellt, daß zwischen dem ersten Abzweig des Leistungsteilers (161) und dem ersten Eingang des Leistungsaddierers (178) die gleiche Laufzeit besteht, wie zwischen dem zweiten Abzweig des Leistungsteilers (161) und dem zweiten Eingang des Leistungsaddierers (178).

Die zweite, die Quadraturkomponente betreffende Hälfte der symetrischen Schaltungsanordnung ist, von einer von der Programmierung des Festwertspeichers (171) unterschiedlichen Programmierung des Festwertspeichers (181) abgesehen, identisch zur ersten Hälfte. Die beiden Schaltungshälften sind über Kreuz verbunden, indem die negierten Ausgänge der Flip-Flops (167) mit den zweiten fünf der zehn parallelen Adresseingänge des Festwertspeichers (181) verbunden sind und die negierten Ausgänge der dem Festwertspeicher (181) vorgeschalteten Flip-Flops (182) mit den zweiten fünf von zehn parallelen Adresseingängen des Festwertspeichers (171) verbunden sind.

Die Anpassung der beschriebenen Schaltungsanordnung an den Mikrowellensender (101) erfolgt durch Einsatz von Festwertspeichern (171) und (181) mit entsprechender Programmierung. Die Ermittlung der optimalen Programmierung erfolgt anhand einer nach Anspruch 23 oder 24 abgewandelten Schaltungsanordnung anstelle der beschriebenen Schaltungsanordnung, die dieser mit der Ausnahme entspricht, daß die Festwertspeicher (171) und (181) durch entsprechende Schreib-Lese-Speicher ersetzt sind, deren gespeicherte Daten während des Betriebs der Schaltungsanordnung manuell

0131725

oder durch einen Rechner verstellt werden können. Für den Grobabgleich der abgewandelten Schaltungsanordnung werden für jede Adresse die in den Schreib-Lese-Speichern gespeicherten Daten nach einem Programm solange verstellt, bis ein von einem Meßempfänger geliefertes Fehlersignal bei allen Adressen minimiert ist. Der Meßempfänger vergleicht die Signale vor und nach der Reihenschaltung aus der abgewandelten Schaltungsanordnung und dem Mikrowellensender (101) nach Betrag und Phase und leitet daraus das Fehlersignal ab. Anschließend wird noch ein Feinabgleich der in den Schreib-Lese-Speichern gespeicherten Daten auf Minimierung der Fehlerrate vorgenommen. Schließlich werden die in den Schreib-Lese-Speichern gespeicherten optimalen Daten in entsprechende Festwertspeicher abgespeichert, die als Festwertspeicher (171) und (181) in die beschriebene Schaltungsanordnung eingesetzt werden.

Die Vorteile der Erfindung bestehen im wesentlichen darin, daß mit relativ geringem Aufwand ein sehr hoher Grad an Kompensationsgenauigkeit erreicht wird, selbst bei Aussteuerung der nichtlinearen Übertragungseinrichtungen bis zur maximalen Ausgangsleistung, was beispielsweise bei Mikrowellensendern in Übertragungssystemen, die hohe Anforderungen an die Linearität stellen, wie digitale Richtfunksysteme mit 16 QAM, eine beträchtliche Steigerung der verfügbaren Leistung bzw. des Wirkungsgrades ermöglicht, und daß weiterhin die eingesetzten, weitgehend integriert aufzubauenden, nichtlinearen Schaltungsanordnungen durch rechnergestützte Programmierung einfach an die betreffenden nichtlinearen Übertragungseinrichtungen angepaßt werden können, was bei Steuerung des Rechners durch einen Meßempfänger, der als Verzerrungsdetektor arbeitet, eine einfache und hochgenaue adaptive Kompensation ermöglicht.

Dipl.-Ing. M. Horn
Europaplatz 6
D-7000 Stuttgart 80

HD E 09/83

## Patentansprüche

1. Verfahren zur Kompensation von nichtlinearen Amplituden- und/oder Phasenverzerrungen in nichtlinearen hochfrequenzseitigen Übertragungseinrichtungen von Übertragungssystemen für analoge oder digitale Übertragungssignale, insbesondere von nichtlinearen Verzerrungen in Mikrowellensendern, gekennzeichnet durch folgende Merkmale:

   a) im Übertragungssystem wird mindestens eine Erkennungsschaltung eingesetzt, die ein pulscodemoduliertes Kennsignal abgibt, das in codierter Form eine lineare oder nichtlineare Funktion der abgetasteten und quantisierten momentanen Leistung oder des abgetasteten und quantisierten Betrags der Hüllkurve des die hochfrequenzseitigen Übertragungseinrichtungen durchlaufenden Übertragungssignals ist

   b) es wird mindestens ein digitaler Umsetzer eingesetzt, der das pulscodemodulierte Kennsignal in ein pulscodemoduliertes Korrektursignal umsetzt

   c) bei der Umsetzung wird jedem Codewort des pulscodemodulierten Kennsignals ein entsprechend den nichtlinearen Übertragungskennlinien der hochfrequenzseitigen Übertragungseinrichtungen vorbestimmbares Codewort des pulscodemodulierten Korrektursignals zugeordnet

   d) im Übertragungssystem wird, der Erkennungsschaltung nachfolgend, mindestens eine Korrekturschaltung eingesetzt, in der das Übertragungssignal als lineare oder nichtlineare Funktion des decodierten pulscodemodulierten Korrektursignals moduliert wird.

2. Verfahren nach Anspruch 1, dadurch gekennzeichnet, daß die Korrekturschaltung in der Niederfrequenzebene und/oder der Zwischenfrequenzebene und/oder der Hochfrequenzebene des Übertragungssystems eingesetzt wird.

3. Verfahren nach Anspruch 1 oder 2, dadurch gekennzeichnet, daß die Erkennungsschaltung in der Niederfrequenzebene und/oder der Zwischenfrequenzebene und/oder der Hochfrequenzebene des Übertragungssystems eingesetzt wird.

4. Verfahren nach einem der vorhergehenden Ansprüche, dadurch gekennzeichnet, daß
   a) der digitale Umsetzer als adressierbarer Speicher ausgebildet ist,
   b) der Speicher als Adressignal das pulscodemodulierte Kennsignal erhält,
   c) der Speicher unter einzelnen Adressworten gespeicherte Datenworte ausliest,
   d) die vom Speicher ausgelesenen Datenworte das pulscodemodulierte Korrektursignal bilden.

5. Verfahren nach Anspruch 4, dadurch gekennzeichnet, daß der adressierbare Speicher als Festwertspeicher ausgebildet ist.

6. Verfahren nach Anspruch 4, dadurch gekennzeichnet, daß
   a) der adressierbare Speicher als Schreib-Lese-Speicher ausgebildet ist,
   b) ein Meßempfänger die Signale vor und hinter der Reihenschaltung aus Korrekturschaltung und hochfrequenzseitigen Übertragungseinrichtungen miteinander vergleicht,

c) der Meßempfänger aufgrund des Vergleichs ein Fehlersignal abgibt,

d) das Fehlersignal einer Bedienungsperson/einem Mikroprozessor zugeführt wird,

e) ein Datensender eingesetzt wird, der zum Abgeben
einstellbarer pulscodemodulierter Datenworte geeignet ist,

f) die Bedienungsperson/der Mikroprozessor über ein
Programm die Elemente der einstellbaren pulscodemodulierten Datenworte entsprechend dem Fehlersignal
verstellt,

g) die einstellbaren pulscodemodulierten Datenworte in
den Schreib-Lese-Speicher eingeschrieben werden,

h) das Verstellen und das Einschreiben für alle Adressen des Schreib-Lese-Speichers solange durchgeführt
wird, bis das Fehlersignal bei optimaler Kompensation der nichtlinearen Verzerrungen der hochfrequenzseitigen Übertragungseinrichtungen minimiert
ist.

7. Verfahren nach einem der vorhergehenden Ansprüche,
dadurch gekennzeichnet, daß die Korrekturschaltung
als Amplitudenmodulator ausgebildet ist.

8. Verfahren nach einem der vorhergehenden Ansprüche,
dadurch gekennzeichnet, daß die Korrekturschaltung
als Phasenmodulator ausgebildet ist.

9. Verfahren nach einem der Ansprüche 1 bis 6, dadurch
abgewandelt, daß die Erkennungsschaltung ein pulscodemoduliertes Kennsignal abgibt, das in codierter Form
eine lineare oder nichtlineare Funktion des abgetasteten und quantisierten Übertragungssignals ist und daß
die Korrekturschaltung dem Übertragungssignal ein
Signal aufaddiert oder das Übertragungssignal durch

dieses Signal ersetzt, das eine lineare oder nichtlineare Funktion des decodierten pulscodemodulierten
Korrektursignals ist.

10. Schaltungsanordnung zum Einschleifen in den niederfrequenten und/oder den zwischenfrequenten und/oder
den hochfrequenten Weg des Übertragungssignals eines
Übertragungssystems, vor oder nach den hochfrequenzseitigen Übertragungseinrichtungen, zur Durchführung
des Verfahrens nach einem der Ansprüche 1 bis 8,
gekennzeichnet durch

    a) eine Erkennungsschaltung, die aus dem Übertragungs-
       signal, das wie im niederfrequenten Weg eines Über-
       tragungssystems mit Quadraturamplitudenmodulation
       auch aus mehreren parallel laufenden Teilübertra-
       gungssignalen bestehen kann, ein pulscodemodulier-
       tes Kennsignal ableitet, das in codierter Form eine
       lineare oder nichtlineare Funktion der abgetasteten
       und quantisierten momentanen Leistung oder des abgetasteten und quantisierten Betrags der Hüllkurve des
       die hochfrequenzseitigen Übertragungseinrichtungen
       durchlaufenden Übertragungssignals ist,

    b) mindestens einen digitalen Umsetzer, der das pulscodemodulierte Kennsignal in ein pulscodemoduliertes
       Korrektursignal umsetzt, wobei jedem Codewort des
       pulscodemodulierten Kennsignals ein entsprechend
       den nichtlinearen Übertragungskennlinien der hoch-
       frequenzseitigen Übertragungseinrichtungen vorbe-
       stimmbares Codewort des pulscodemodulierten Korrek-
       tursignals zugeordnet wird,

    c) mindestens eine Korrekturschaltung, in der das Über-
       tragungssignal als lineare oder nichtlineare Funk-
       tion des decodierten pulscodemodulierten Korrektur-
       signals moduliert wird.

11. Schaltungsanordnung zum Einschleifen in den niederfrequenten oder den zwischenfrequenten oder den hochfrequenten Weg des Übertragungssignals eines Übertragungssystems, vor oder nach den hochfrequenzseitigen Übertragungseinrichtungen, zur Durchführung des Verfahrens nach Anspruch 9, gekennzeichnet durch

a) eine Erkennungsschaltung, die aus dem Übertragungssignal, das wie im niederfrequenten Weg eines Übertragungssystems mit Quadraturamplitudenmodulation auch aus mehreren parallel laufenden Teilübertragungssignalen bestehen kann, ein pulscodemoduliertes Kennsignal ableitet, das in codierter Form eine lineare oder nichtlineare Funktion des abgetasteten und quantisierten Übertragungssignals ist,

b) mindestens einen digitalen Umsetzer, der das pulscodemodulierte Kennsignal in ein pulscodemoduliertes Korrektursignal umsetzt, wobei jedem Codewort des pulscodemodulierten Kennsignals ein entsprechend den nichtlinearen Übertragungskennlinien der hochfrequenzseitigen Übertragungseinrichtungen vorbestimmbares Codewort des pulscodemodulierten Korrektursignals zugeordnet wird,

c) mindestens eine Korrekturschaltung, in der dem Übertragungssignal ein Signal aufaddiert oder das Übertragungssignal durch dieses Signal ersetzt wird, das eine lineare oder nichtlineare Funktion des decodierten pulscodemodulierten Korrektursignals ist.

12. Schaltungsanordnung nach Anspruch 10, zur Anwendung in der Zwischenfrequenzebene und/oder der Hochfrequenzebene eines Übertragungssystems, dadurch gekennzeichnet, daß zwischen ihrem Eingang und ihrem Ausgang eine Reihenschaltung aus einer ersten Verzweigungsschaltung (11), einem an den ersten Abzweig der ersten Verzweigungsschaltung (11) angeschlossenen Lauf-zeitausgleichsglied (12), einer zweiten Verzweigungs-schaltung (13), einer mit ihrem ersten Eingang an den ersten Abzweig der zweiten Verzweigungsschaltung (13) angeschlossenen Modulatorschaltung (14) und einer mit ihrem ersten Eingang an die Modulatorschaltung (14) angeschlossenen Summierschaltung (15) liegt, daß der zweite Abzweig der ersten Verzweigungsschaltung (11) mit dem zweiten Eingang der Modulatorschaltung (14) über eine Reihenschaltung aus einem Hüllkurvendetektor (16), einem Analog-Digital-WAndler (17), einem mit seinem Adresseingang an den Analog-Digital-Wandler (17) angeschlossenen adressierbaren Speicher (18) und einem an den Datenausgang des adressierbaren Speichers (18) angeschlossenen Digital-Analog-Wandler (19) verbunden sind und daß der zweite Abzweig der zweiten Verzweigungsschaltung (13) mit dem zweiten Eingang der Summierschaltung (15) über ein Dämpfungsglied (21) und ein Phasendrehglied (22) verbunden sind.

13. Schaltungsanordnung nach Anspruch 12, dadurch gekennzeichnet, daß die Modulatorschaltung (14) als Amplituden- oder Phasenmodulator ausgebildet ist.

14. Schaltungsanordnung nach Anspruch 10, zur Anwendung in der Niederfrequenzebene eines Übertragungssystems mit Quadraturamplitudenmodulation, dadurch gekennzeichnet, daß zwischen ihrem ersten Eingang und ihrem ersten Ausgang eine Reihenschaltung aus einer ersten Verzweigungsschaltung (24), einem an den ersten Abzweig der ersten Verzweigungsschaltung (24) angeschlossenen ersten Laufzeitausgleichsglied (25) und einem mit seinem ersten Eingang an das erste Lauf-zeitausgleichsglied (25) angeschlossenen ersten Ampli-tudenmodulator (26) liegt, daß zwischen ihrem zweiten Eingang und ihrem zweiten Ausgang eine Reihenschaltung aus einer zweiten Verzweigungsschaltung (27), einem an den ersten Abzweig der zweiten Verzweigungsschaltung (27) angeschlossenen zweiten Laufzeitausgleichsglied (28) und einem mit seinem ersten Eingang an das zweite Laufzeitausgleichsglied (28) angeschlossenen zweiten Amplitudenmodulator (29) liegt, daß zwischen dem zweiten Abzweig der ersten Verzweigungsschaltung (24) und dem ersten Eingang einer digitalen Addierschaltung (31) eine Reihenschaltung aus einem ersten Analog-Digital-Wandler (32) und einer ersten digitalen Quadrierschaltung (33) liegt, daß zwischen dem zweiten Abzweig der zweiten Verzweigungsschaltung (27) und dem zweiten Eingang der digitalen Addierschaltung (31) eine Reihenschaltung aus einem zweiten Analog-Digital-Wandler (34) und einer zweiten digitalen Quadrierschaltung (35) liegt, daß der digitalen Addierschaltung (31) eine dritte Verzweigungsschaltung (36) nachgeschaltet ist, daß zwischen dem ersten Abzweig der dritten Verzweigungsschaltung (36) und dem zweiten Eingang des ersten Amplitudenmodulators (26) eine Reihenschaltung aus einem ersten mit seinem Adresseingang an den ersten Abzweig der dritten Verzweigungsschaltung (36) angeschlossenen adressierbaren Speicher (37) und einem an den Datenausgang des ersten adressierbaren Speichers (37) angeschlossenen ersten Digital-Analog-Wandler (38) liegt und daß zwischen dem zweiten Abzweig der dritten Verzweigungsschaltung (36) und dem zweiten Eingang des zweiten Amplitudenmodulators (29) eine Reihenschaltung aus einem zweiten mit seinem Adresseingang an den zweiten Abzweig der dritten Verzweigungsschaltung (36) angeschlossenen adressierbaren Speicher (39) und einem an den Datenausgang des zweiten adressierbaren Speichers (39) angeschlossenen zweiten Digital-Analog-Wandler (41) liegt.

15. Schaltungsanordnung nach Anspruch 14, dadurch abgewandelt, daß die Reihenschaltung aus zweitem adressierbarem Speicher (39) und zweitem Digital-Analog-Wandler (41) entfernt ist, daß die dritte Verzweigungsschaltung (36) nach dem ersten Digital-Analog-Wandler (38) angeordnet ist, daß der erste Abzweig der dritten Verzweigungsschaltung (36) mit dem zweiten Eingang des ersten Amplitudenmodulators (26) und daß der zweite Abzweig der dritten Verzweigungsschaltung (36) mit dem zweiten Eingang des zweiten Amplitudenmodulators (29) verbunden ist.

16. Schaltungsanordnung nach Anspruch 14 oder 15, dadurch abgewandelt, daß die Reihenschaltung aus erstem Analog-Digital-Wandler (32) und erster digitaler Quadrierschaltung (33) ersetzt ist durch eine erste analoge Quadrierschaltung, daß die Reihenschaltung aus zweitem Analog-Digital-Wandler (34) und zweiter digitaler Quadrierschaltung (35) ersetzt ist durch eine zweite analoge Quadrierschaltung und daß die digitale Addierschaltung (31) ersetzt ist durch eine Reihenschaltung aus einer analogen Addierschaltung und einem Analog-Digital-Wandler.

17. Schaltungsanordnung nach Anspruch 11, dadurch gekennzeichnet, daß zwischen ihrem Eingang und ihrem Ausgang eine Reihenschaltung aus einem Analog-Digital-Wandler, einem mit seinem Adresseingang an den Analog-Digital-Wandler angeschlossenen adressierbaren Speicher und einem an den Datenausgang des adressierbaren Speichers angeschlossenen Digital-Analog-Wandler liegt.

18. Schaltungsanordnung nach Anspruch 11, zur Anwendung in der Niederfrequenzebene eines Übertragungssystems mit Quadraturamplitudenmodulation, dadurch gekennzeichnet, daß zwischen ihrem ersten Eingang und ihrem ersten Ausgang eine Reihenschaltung aus einem ersten Analog-Digital-Wandler (43), einer ersten Verzweigungsschaltung (44), einem mit seinem ersten von zwei parallelen Adresseingängen an den ersten Abzweig der ersten Verzweigungsschaltung (44) angeschlossenen ersten adressierbaren Speicher (45) und einem an den Datenausgang des ersten adressierbaren Speichers (45) angeschlossenen ersten Digital-Analog-Wandler (46) liegt, daß zwischen ihrem zweiten Eingang und ihrem zweiten Ausgang eine Reihenschaltung aus einem zweiten Analog-Digital-Wandler (47), einer zweiten Verzweigungsschaltung (48), einem mit seinem ersten von zwei parallelen Adresseingängen an den ersten Abzweig der zweiten Verzweigungsschaltung (48) angeschlossenen zweiten adressierbaren Speicher (49) und einem an den Datenausgang des zweiten adressierbaren Speichers (49) angeschlossenen zweiten Digital-Analog-Wandler (51) liegt, daß der zweite der zwei parallelen Adresseingänge des ersten adressierbaren Speichers (45) mit dem zweiten Abzweig der zweiten Verzweigungsschaltung (48) und der zweite der zwei parallelen Adresseingänge des zweiten adressierbaren Speichers (49) mit dem zweiten Abzweig der ersten Verzweigungsschaltung (44) verbunden ist und daß die zwei parallelen Adresseingänge der Speicher einen Gesamtadresseingang für die Speicher darstellen.

19. Schaltungsanordnung nach einem der Ansprüche 12 bis 18, dadurch gekennzeichnet, daß der adressierbare Speicher als Festwertspeicher ausgebildet ist.

20. Schaltungsanordnung nach einem der Ansprüche 12,13, 16,17, dadurch abgewandelt, daß die Reihenschaltung aus Analog-Digital-Wandler und adressierbarem Speicher durch einen Analog-Digital-Wandler mit nichtlinearer Wandlungscharakteristik ersetzt ist.

21. Schaltungsanordnung nach einem der Ansprüche 12 bis 18 dadurch gekennzeichnet, daß der adressierbare Speicher als Schreib-Lese-Speicher ausgebildet ist.

22. Schaltungsanordnung nach Anspruch 21, dadurch abgewandelt, daß dem Schreib-Lese-Speicher (53) eine Verzweigungsschaltung (54) vorgeschaltet ist, daß der erste Abzweig der Verzweigungsschaltung (54) mit dem Adresseingang des Schreib-Lese-Speichers (53) verbunden ist, daß der zweite Abzweig der Verzweigungsschaltung (54) mit dem ersten Eingang einer Komparatorschaltung (55) verbunden ist, daß der zweite Eingang der Komparatorschaltung (55) mit einer Adress-Eingabe-Leitung (56) verbunden ist, daß der Ausgang der Komparatorschaltung (55) mit einem ersten Eingang einer Logikschaltung (57) verbunden ist, daß der zweite Eingang der Logikschaltung (57) mit einer Schreib-Befehl-Signal-Eingabe-Leitung (58) verbunden ist, daß der erste Ausgang der Logikschaltung (57) mit dem Schreib-Freigabe-Eingang des Schreib-Lese-Speichers (53) verbunden ist, daß der zweite Ausgang der Logikschaltung (57) mit einer Schreib-Bestätigungs-Signal-Ausgabe-Leitung (59) verbunden ist, daß der Dateneingang des Schreib-Lese-Speichers (53) mit einer Daten-Eingabe-Leitung (61) verbunden ist und daß die Logik der Logikschaltung (57) darin besteht, daß sie dann an den Schreib-Freigabe-Eingang des Schreib-Lese-Speichers (53) für kurze Zeit das notwendige Schreib-Freigabe-Signal anlegt und auf die Schreib-Bestätigungs-Signal-Ausgabe-Leitung (59)

**0131725**

ein vereinbartes Signal abgibt, wenn sie, nachdem ihr auf der Schreib-Befehl-Signal-Eingabe-Leitung (58) ein vereinbartes Signal zugeführt worden ist, von der Komparatorschaltung (55) das Signal für Gleichheit seiner beiden Eingangssignale erhält, sodaß in den Schreib-Lese-Speicher (53) unter der auf der Adress-Eingabe-Leitung (56) von außen zugeführten Adresse die auf der Daten-Eingabe-Leitung (61) von außen zugeführten Daten unter kurzzeitigem Umschalten des Schreib-Lese-Speichers (53) vom Lese- im den Schreibmodus dann eingeschrieben werden, wenn, nachdem auf der Schreib-Befehl-Signal-Eingabe-Leitung (58) ein Schreib-Befehl zugeführt worden ist, am Adresseingang des Schreib-Lese-Speichers (53) die auf der Adress-Eingabe-Leitung (56) von außen zugeführte Adresse erscheint.

23. Schaltungsanordnung nach Anspruch 22, dadurch gekennzeichnet, daß die Adress-Eingabe-Leitung (56), die Daten-Eingabe-Leitung (61), die Schreib-Befehl-Signal-Eingabe-Leitung (58) sowie die Schreib-Bestätigungs-Signal-Ausgabe-Leitung (59) an einen auf eine rechnergestützte Eingabe der Adressen, Daten und des Schreib-Befehl-Signals programmierten Rechner/Mikroprozessor angeschlossen sind, dem die zur Ausführung seines Programms notwendigen Informationen manuell und/oder durch Abruf aus einem Speichermedium und/oder in Form von mathematischen Gleichungen und/oder in Form eines von einem Meßempfänger gelieferten Fehlersignals eingegeben und angezeigt werden können, in Form einer Tabelle, einer Graphik oder einer mathematischen Gleichung.

24. Schaltungsanordnung nach Anspruch 22, dadurch gekennzeichnet, daß die Adress-Eingabe-Leitung (56), die Daten-Eingabe-Leitung (61) und die Schreib-Befehl-Signal-Eingabe-Leitung (58) mit einer Vorrichtung zur manuellen Eingabe der Adressen, Daten und des Schreib-Befehl-Signals verbunden sind und daß die Schreib-Bestätigungs-Signal-Ausgabe-Leitung (59) mit einer Anzeigevorrichtung verbunden ist.

25. Schaltungsanordnung nach einem der Ansprüche 12 bis 18, dadurch abgewandelt, daß der adressierbare Speicher durch eine digitale Rechenschaltung ersetzt ist.

FIG. 1

FIG. 2

FIG. 3

FIG. 4

FIG. 5

0131725

HD E 09/83

FIG. 6

FIG. 7

FIG. 8

FIG. 9

HD E 09/83

0131725